# EUROPEAN PATENT SPECIFICATION

(11) **EP 0 642 137 B1**
(45) Date of publication and mention of the grant of the patent: **28.11.2001**
(21) Application number: 94202481.1
(22) Date of filing: 31.08.1994
(51) Int. Cl.: G11C 29/00

(54) **Quiescent-current testable RAM**
Ruhestromprüfbarer RAM
Mémoire à accès aléatoire à possibilité de test du courant de repos

(30) Priority: 01.09.1993 EP 93202555
(43) Date of publication of application: 08.03.1995
(73) Proprietor: Koninklijke Philips Electronics N.V., 5621 BA Eindhoven (NL)
(72) Inventor: Sachdev, Mamoj, c/o Int, Octrooibureau B.V., 5656 AA Eindhoven (NL)
(74) Representative: Duijvestijn, Adrianus Johannes

(56) References cited:
- EP-A- 0 264 893
- RECORDS OF THE 1993 IEEE INTERNATIONAL WORKSHOP ON MEMORY TESTING, 9 - 10 August 1993, SAN JOSE, CA, USA, pages 137-142, XP002039231 YOKOYAMA H, TAMAMOTO H, NARITA Y: "A current testing for CMOS static RAMS"
- PATENT ABSTRACTS OF JAPAN vol. 016, no. 583 (P-1462), 22 December 1992 & JP 04 232693 A (TOSHIBA CORP), 20 August 1992, & US 5 276 647 A (MATSUI MASATAKA ET AL) 4 January 1994

## Description

### FIELD OF THE INVENTION

The invention relates to electronic circuitry with a memory having a plurality of memory cells that are functionally organized in rows and columns.

### BACKGROUND ART

Systematic and automatic testing of electronic circuitry, and of integrated circuits in particular, becomes increasingly more important. Each next generation of circuits tends to develop ever higher component densities and an ever growing number of system functionalities. Individual circuits have become complicated to such an extent that process defects cannot be detected and located anymore save by exhaustive and expensive testing. Customers cannot be expected to accept circuitry products that show their hidden defects in operational use, thereby rendering, e.g., life support systems or aircraft control systems, unreliable. It is therefore of the utmost importance for both the manufacturer and the customer that tests are run to guarantee flawless operation of the circuit products.

Random access memories (SRAMs, DRAMs) are usually subjected to march tests and/or data retention tests. In a march test, a sequence of read and/or write operations are applied to every cell of the memory, either in increasing or decreasing address order. In data retention tests, every cell is written and checked after a pre-specified wait-time to see whether or not current leakage has occurred that has affected the stored logic state. Note that memory cells in a bit oriented memory and groups of memory cells in a word-oriented memory are accessible only successively, thus giving rise to lengthy test procedures.

Conventional testing of semiconductor memories that have a storage capacity in the order of 1 Mbit or larger makes up a considerable percentage of the production costs. For, e.g., a 4 Mbit DRAM this percentage well amounts to 10%. For larger memories, this percentage increases even further as the time required to conduct the test grows with extension of the storage capacity. For a 64 Mbit DRAM testing is estimated to cost 240 times as much as testing a 1 Mbit DRAM. This should imply that the ratio of the test cost and the total cost of a 64 Mbit DRAM then amounts to approximately 40%, which is unacceptably high. Accordingly, with increasing transistor densities and with increasing number of system functionalities that can be integrated on a semiconductor substrate (including wafer scale devices), prior art testing has become a major factor in determining the commercial viability of an IC memory product. For further information, see "A New Testing Acceleration Chip for Low-Cost Memory Tests", M. Inoue et al., IEEE Design & Test of Computers, March 1993, pp. 15-19.

Quiescent-current testing (I_{DDQ}-testing), also referred to as current supply monitoring method (CSM), of an integrated circuit aims at locating process defects in the circuit by monitoring the quiescent currents. The I_{DDQ}-testing technique has shown a lot of promise in the analysis of actual process defects in static CMOS ICs. The quiescent current, or steady state current, in a CMOS logic circuit should be very small, e.g., in the order of 1*µ*A. Any deviation is therefore easily detected. The potential of this testing technique is substantial in terms of cost reduction, and of quality and reliability enhancement.

Typical examples of defects occurring in ICs are stuck-at faults and gate oxide defects. Stuck-at faults are symptoms caused by unintended electrically conductive interconnections between circuit nodes and supply lines, thereby effecting a hard-wired pull-up or pull-down that interferes with the circuit's logic operation. A bridging fault formed by a conductive bridge of low resistance between a supply line and a signal line causes stuck-at phenomena. Impact of gate-oxide defects is often parametric in nature, i.e., not defined in terms of logic voltage levels, and is therefore not detected by conventional voltage methods. Gate-oxide defects may also give rise to stuck-at behaviour. Typically, I_{DDQ}-testing detects such faults.

However, certain classes of circuits conventionally are not I_{DDQ}-testable owing to their specific configuration. DRAMs are an example of one such a class. If there is a defect in a DRAM's memory cell, such as in the gate oxide, the charge stored at the cell's capacitor leaks away. Therefore, in a quiescent state a current does not flow and, accordingly, is esentially not detectable through I_{DDQ}-measurements. At present, such defects are detected either by aforementioned conventional march tests or tedious data retention tests, depending on the type of faults expected. Although SRAMs can be subjected to I_{DDQ}-testing, it is not an attractive option owing to the costs, as the SRAM cells are only individually accessible.

RECORDS OF THE 1993 IEEE INTERNATIONAL WORKSHOP ON MEMORY TESTING, Aug, 1993, pages 137-142 discloses a method for current testing for CMOS static RAM's.

### OBJECT OF THE INVENTION

It is an object of the invention to provide a means to test memories in general, and DRAMs and SRAMs in particular, by I_{DDQ} measurements. It is another object to reduce costs involved in testing semiconductor random access memories by I_{DDQ}- and/or voltage methods.

### SUMMARY OF THE INVENTION

To this end, the invention provides an electronic circuitry with a memory having a plurality of memory cells functionally organized in rows and columns, at least non-defective ones of said memory cells not having hot-electron injection or Fowler-Nordheim tunneling induced during testing, characterized in that the circuitry comprises test circuitry for being selectively operative to connect and access simultaneously and in parallel a selective number of at least two memory cells of at least a particular one of the columns and to simultaneously subject said at least two memory cells to a quiescent current test.

Normally, only one bit cell per column is accessed to retrieve or store data in the conventional way. In normal memory operation, accessing two (or more) cells of the same column in parallel would imply inefficient duplication when storing data and annihilation when retrieving data. In the invention, the memory is put into a test mode, wherein two or more cells of at least a particular one of the columns are accessed in parallel. That is, these cells are rendered simultaneously accessible by interconnecting them in parallel. Accordingly, if the cells are subjected to a quiescent non-zero voltage and if any cell shows a defect that manifests itself through current leakage, then this is detectable through an I_{DDQ}-measurement conducted on all cells arranged in parallel. Note that some sort of parallel access occurs in a flash EEPROM during an erasure operation. This, however, serves a completely different purpose than that of I_{DDQ}-testing, and involves Fowler-Nordheim tunneling or hot-electron injection. For further details on Flash memories, see, e.g., Intel, Memory Products Data Handbook, 1992, pp. 3-320- 3-323.

An example of a defect that is discoverable in this manner is a short circuit between data retention nodes, e.g., the capacitor of a DRAM cell or the interconnections of the cross-coupled inverters in an SRAM cell, and a supply line. Another example of such a defect is a faulty gate oxide of a FET capacitor in a DRAM cell. Both examples fall into the category of data retention faults that show up as a current leak.

Preferably, the test means are operative to access in parallel the cells of a plurality of columns or all cells of all columns in parallel. In this manner, it is easily detected whether or not there is a faulty cell in a specific memory segment comprised of the plurality of columns or in the integral memory, respectively.

The test means can be operative to first access in parallel all memory cells of all columns of the memory and, if thereby causing a current through the memory larger than a predetermined threshold, to then access in parallel all cells of fewer than all columns. If the presence of a faulty cell is thus detected, and if it is desirable to locate the defect, then the columns and rows of the examined segment or memory can thereupon be scanned according to an efficient search procedure, e.g., by successively halving the memory area to be probed until the defect's position is sufficiently accurately known. This procedure can be used to functionally eliminate faulty cells, e.g., by replacing a column comprising such defect by a spare column under control of the I_{DDQ}-test results, given the fact that the memory is provided with redundancy features.

In a typical random access memory, the cells in a row are all connected to a word line, and the cells in a columns are connected to single bit line, such as in a DRAM with a single cell per bit, or between a bit line and a bit-bar line, such as in an SRAM or in a DRAM with a dual-cell per bit. In the invention, the test means are operative to activate all or specific ones of said word lines connected to the given number of cells of the particular one of the columns, and to drive a particular one of the bit lines, which is associated with the particular column, by a quiescent voltage.

Suppose that in the test mode all bit cells of all columns of a single-cell-per-bit DRAM are connected in parallel. This is accomplished by activating all word lines. Now, driving all bit lines with a logic high, e.g., a supply voltage V_{DD} of, say, 3,3 Volts via the conventional bit line drivers or pre-charging logic, results in a high voltage of 3,3 Volts over each and every cell. If there is a current leak, then this is spotted in the I_{DDQ} measurements. Driving bit lines of adjacent columns with complementary logic voltages permits detection of short circuits between the bit lines via I_{DDQ} measurements. Some DRAMs are provided with dual cells that store complementary logic states in a pair of complementarily charged capacitors, together forming a single bit of information. Driving the bit lines and the bit-bar lines with V_{DD} then discovers defects caused by leakage currents to ground, and driving the bit lines and bit-bar lines with GND allows of discovering defects caused by leakage currents to V_{DD}.

A similar procedure can be applied to SRAMs. Each column in an SRAM comprises a pair of bit lines, called bit line and bit-bar line. An SRAM cell is connected to the bit line and to the bit-bar line. Driving all bit lines high and all bit-bar lines low, the cells all being connected in parallel by having them simultaneously accessed, permits checking stuck-at defects and data retention defects relating to a first logic state of the cells. Driving all bit-bar lines high and all bit lines low, while the cells are all connected in parallel, permits checking stuck-at defects and data retention defects relating to a second logic state of the cells.

The concept of the invention can be implemented in a variety of ways. For example, all word lines are disconnected from the row decoder and are driven high, i.e., enabled, in the test mode, e.g., by pass-transistors. Alternatively, part of the word lines or single ones of the word lines may be enabled in the test mode in order to detect and also to locate a possible failure. The bit lines and bit-bar lines can be driven high or low by using the pre-charge logic or the bit line drivers. The test means can simply be a sequential machine generating two codes, in addition to a code for the memory's normal operation mode, so that the bit lines and bit-bar lines can be driven high as well as low from the pre-charge logic.

A method in accordance with the invention may be applied to conventional memories, i.e., those without the test means physically integrated with the memory. To this end, appropriate probes can be located to contact the word lines, bit lines and memory supply lines to supply them with the required voltages to carry out the I_{DDQ}-test. However, this requires as an additional step accurate positioning of the probes, thereby introducing an additional source of errors and delay. It is therefore to be preferred to have the test means physically integrated with the electronic circuit, either on each chip or on the wafer as a test feature shared by all circuitry on the wafer.

The invention is particularly relevant to DRAMs and SRAMs. The invention, i.e., connecting in parallel elements of a structured array in order to conduct tests, is also applicable to testing CCD (charge coupled device) memories and LCDs (liquid crystal displays). CCDs are serial memories wherein amounts of electric charge are serially shifted through a sequence of potential wells, i.e., memory cells, created under clock signal control and typically arranged in a two-dimensional matrix. Applying patterns of stationary control signals instead of dynamic clock signals renders the CCD testable, e.g., through I_{DDQ} measurements, at least as far as the integrity of the clock lines is concerned. An LCD typically comprises a two-dimensional array of crystals (cells), whose optical states are individually controllable by supplying appropriate control voltages via a grid of conductors. Note that the LCD's crystals in normal operation are driven by time-dependent control signals in order not to damage the crystals. Applying patterns of test time-dependent voltages to the grid and measuring the associated time-averaged currents provides an indication of whether or not there are defective cells.

The invention is extendable to other kinds of electronic circuitry, typically those having an array structure. For example, an organization of random accessible or sequentially accessible processing elements or stations interconnected via a shared bus could be I_{DDQ}-tested similarly by connecting them in parallel in a test mode.

### BRIEF DESCRIPTION OF THE DRAWING

The invention is explained hereinafter by way of example and with reference to the accompanying drawing, wherein:
Fig. 1 gives a diagram of a circuit with a DRAM in the invention;
Fig. 2 gives a diagram of a typical DRAM cell to illustrate defects;
Fig. 3 gives a diagram of a circuit with an SRAM in the invention; and
Fig. 4 gives a diagram of a typical SRAM cell to illustrate defects.

Throughout the drawing, similar or corresponding features are indicated with the same reference numerals.

### DETAILED EMBODIMENTS

Random access read/write semiconductor memories can be divided basically in two categories, namely SRAMs and DRAMS. The term "SRAM" stands for static random access memory and refers to a memory in which the data content is retained in the absence of control signals, provided its power supply remains energized. Typically, an SRAM cell comprises a bistable circuit, such as a pair of cross-coupled logic inverters. A logic high is stored by having a first one of the inverters providing a logic high and the other a logic low, whereas a logic low is stored by having the other one of the inverters providing a logic high and the first one a logic low. The term DRAM stand for dynamic random access memory and refers to a memory in which the memory cells require repetitive application of control signals (refresh signals) in order to retain the data stored. This repetitive control operation is known as a "refresh cycle". Typically, a DRAM cell comprises a capacitor to store a single bit of information as an amount of electrical charge. A logic high is represented by an amount of charge exceeding a pre-specified threshold, and a logic low is represented by an amount of charge smaller than the threshold. Alternatively, a DRAM may be comprised of dual cells that store complementary logic states in a pair of complementarily charged capacitors, together forming a single bit of information.

### DRAM cell

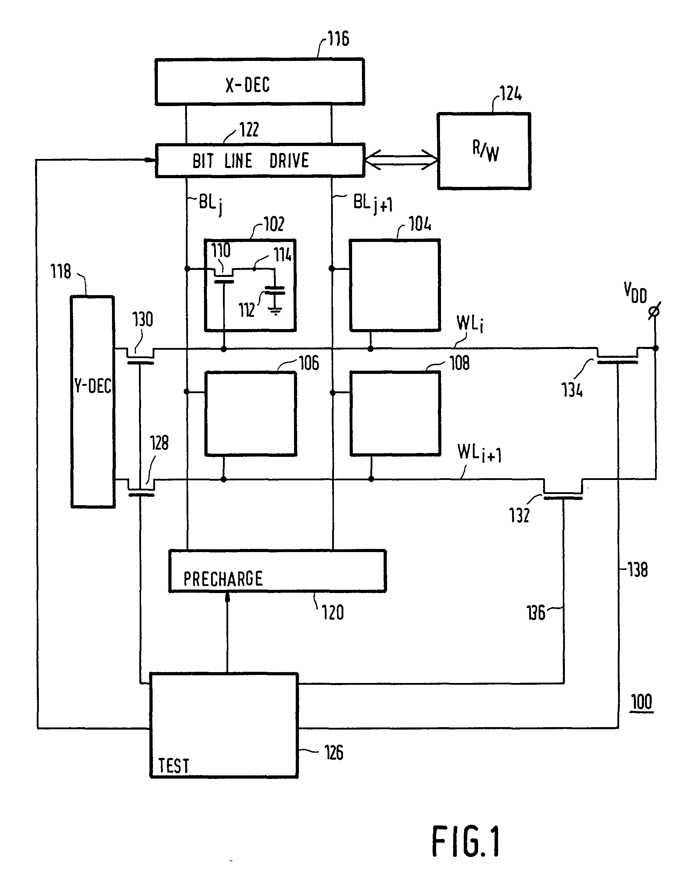

Fig. 1 gives a diagram of DRAM 100. DRAM 100 comprises a plurality of uniform bit cells, of which only cells 102, 104, 106 and 108 are indicated explicitly. The cells are functionally organized in rows and columns. The cells of rows i and i+1 are connected to word lines WLᵢ and WLᵢ₊₁, respectively. The cells of columns j and j+1 are connected to bit lines BLⱼ and BLⱼ₊₁, respectively. Since the cells are uniform, only cell 102 is discussed in further detail. Cell 102 is located in row i and in column j. Cell 102 includes an access transistor 110 that has a current channel connected to bit line BLⱼ and that has a control electrode connected to word line WLᵢ. Cell 102 further includes a capacitor 112 that is connected between the current channel of transistor 110 via a node 114 and a V_{SS} supply line, commonly referred to as "plate". A single bit of information is stored in cell 102 as an amount of electrical charge in capacitor 112. A logic high is represented by a charge exceeding a pre-specified threshold and a logic low is represented by a charge below the threshold.

DRAM 100 further includes an X decoder 116, an Y decoder 118, pre-charging logic 120, bit line drivers 122 and read/write circuitry 124. Since decoders 116 and 118, pre-charging logic 120, bit line drivers 122 and read/write circuitry 124 are all well known conventional parts of a DRAM, neither the implementation of these parts nor their conventional operation need be discussed here in further detail.

DRAM 100 also comprises features to permit I_{DDQ}-testing of the memory. A test control block 126 is operative in the test mode to turn off transistors 128-130 arranged between the word lines, among which WLᵢ and WLᵢ₊₁, and Y decoder 118, and to turn on transistors 132-134 arranged between the word lines and a power supply node carrying V_{DD}. This causes all cells 102, 104, 106 and 108 to be connected to their respective bit lines. Further, test control block 126 is operative to drive the bit lines, among which are BLⱼ and BLⱼ₊₁, for example via pre-charging logic 120 or via bit line drivers 122. For instance, the bit lines are all driven to 3,3 Volts. This causes all cells to be connected in parallel, namely, between V_{DD} and ground. Any defect that gives rise to current leakage in any cell is revealed through current measurements in the I_{DDQ}-test, e.g., by measuring the current drawn from the supply nodes of the shown circuit. In fact, all cells are scanned simultaneously, thus realizing a highly efficient quality check. In Fig. 1, transistors 132-134 can be made individually controllable by test control block 126 via individual control lines 136 and 138, respectively. This permits not only detecting the presence but also the location of a fault. Alternatively, transistors 132-134 may be turned on and turned off simultaneously by a single control line (not shown here). The latter embodiment then requires less substrate area for the control lines to control transistors 132-134.

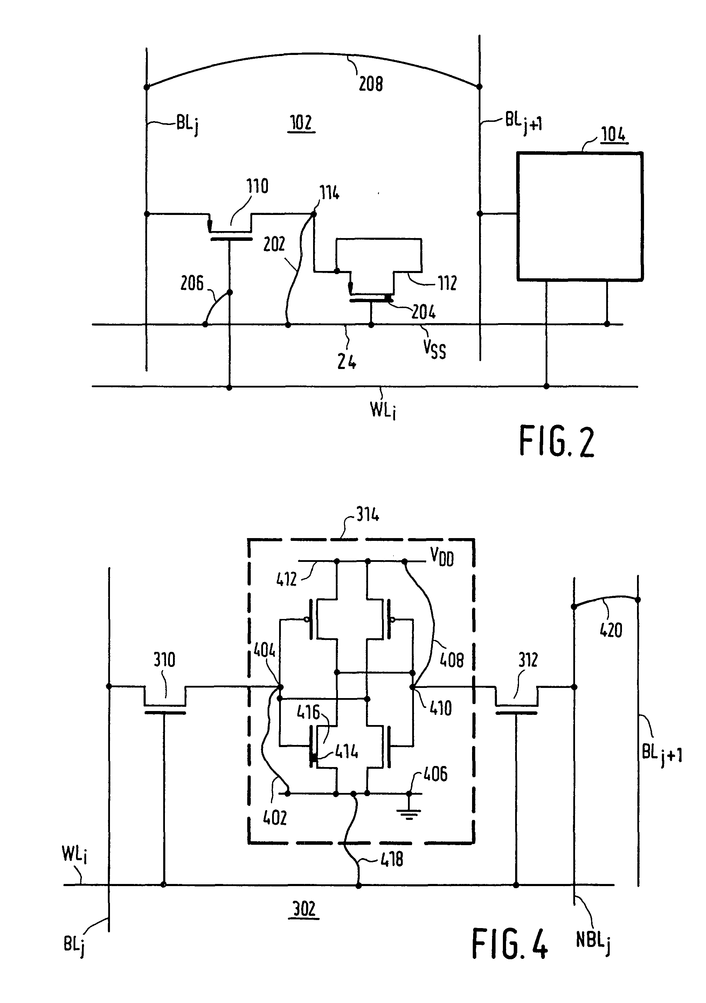

Turning now to Fig. 2, cell 102 may be faulty in a variety of ways. A first defect that can occur is a short-circuit 202 from node 114 to V_{SS} supply line 24. A second fault could be a gate oxide defect 204 bridging the gate oxide of transistor 112 that is connected as capacitor. Defects 202 and 204 can cause memory cell 102 to have either a stuck-at-0 fault or a data retention fault, depending on the resistance of the defect. These defects are conventionally detected by monitoring a Write/Read operation or a data retention test. However, assume that cell 102 has a gate oxide defect 204, which causes charge to leak slowly away to V_{SS}. If a logic 1 is written and read in quick succession, and if the resistance is high enough, the read operation can be successful in finding the same logic value as was written. Therefore, defect 204 need not be discovered using conventional test procedures. A quiescent current measurement traditionally conducted is not able to detect fault 204 either, since leakage current in this case flows only or a short time. This is due to the fact that the capacitance of capacitor 112 is very small, typically in the order of 50 fF for the multi-Mbit memories, and accordingly holds very little charge. This defect is detected by the conventional data retention test. In the invention, however, the I_{DDQ} test scans all statically activated cells in parallel to discover this defect. A third possible defect is a short-circuit 206 from word line WLᵢ to the V_{SS} supply line. This defect prevents access transistor 110 from being turned on, thereby permanently disabling memory cell 102. The I_{DDQ} measurements in the invention scan all cells in parallel and also detect this type of defect as it gives rise to a relatively large current. A fourth possible fault is a short circuit 208 between adjacent bit lines, which is likely to occur in large capacity DRAMs whose cells are extremely small, typically in the order of 1.5*µ*m², and therefore have a small column pitch. This defect 208 is readily detected in an I_{DDQ}-test according to the invention by having adjacent bit lines supplied with supply voltage V_{DD} and V_{SS} alternately. Above examples may serve to illustrate the powerful test capability of a DRAM provided with test means according to the invention.

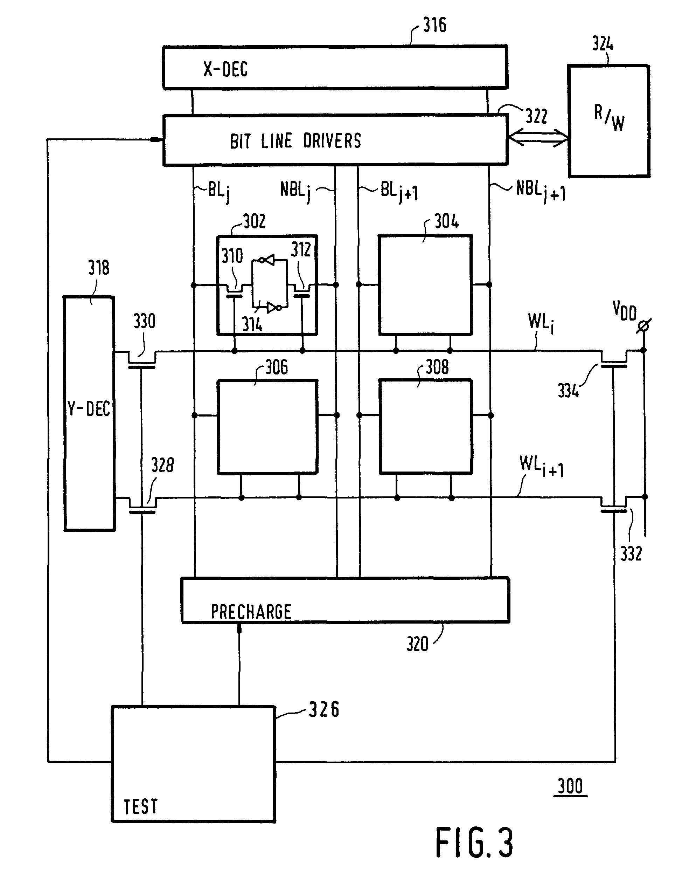

Fig. 3 illustrates an SRAM 300. SRAM 300 comprises a plurality of uniform bit cells, of which only cells 302, 304, 306 and 308 are indicated explicitly. The cells are functionally organized in rows and columns. The cells of rows i and i+1 are connected to word lines WLᵢ and WLᵢ₊₁, respectively. The cells of columns j and j+1 are connected to bit line BLⱼ and bit-bar line NBLⱼ, and bit line BLⱼ₊₁ and bit-bar line NBLⱼ₊₁, respectively. Since the cells are uniform, only cell 302 is discussed in further detail. Cell 302 is located in row i and in column j. Cell 302 includes a first access transistor 310 that has a current channel connected to bit line BLⱼ and that has a control electrode connected to word line WLᵢ, a second access transistor 312 that has a current channel connected to bit-bar line NBLⱼ and that has a control electrode also connected to word line WLᵢ, and a latch 314 connected between the current channels of first and second access transistors 310 and 312. Latch 314 comprises two cross-coupled inverters arranged between supply voltage nodes (not shown). A single bit of information is stored in cell 302 as one of two stable states of latch 314.

SRAM 300 further includes an X decoder 316, an Y decoder 318, pre-charging logic 320, bit line drivers 322 and read/write circuitry 324. Since decoders 316 and 318, pre-charging logic 320, bit line drivers 322 and read/write circuitry 324 are all well known conventional parts of an SRAM, neither the implementation of these parts nor their conventional operation need be discussed here in further detail.

SRAM 300 also comprises features to permit I_{DDQ}-testing of the memory. A test control block 326 is operative in the test mode to turn off transistors 328-330 arranged between the word lines, among which WLᵢ and WLᵢ₊₁, and Y decoder 318, and to turn on transistors 332-334 arranged between the word lines and a power supply node carrying V_{DD}. This causes all cells 302, 304, 306 and 308 to be connected to their respective bit lines and bit-bar lines. Further, test control block 326 is operative to drive the bit lines and bit-bar lines, among which are BLⱼ, NBLⱼ, BLⱼ₊₁ and NBLⱼ₊₁, for example via pre-charging logic 320 or via bit line drivers 322. For instance, the bit lines are all driven to 3,3 Volts and the bit-bar lines are grounded. This causes all cells to be connected in parallel, namely, between V_{DD} and ground. Any defect that gives rise to current leakage in any cell in a first logic state is revealed through current measurements in the I_{DDQ}-test, e.g., by measuring the current drawn from the supply nodes of the shown circuit. The bit-bar lines thereupon are all driven to 3,3 Volts and the bit lines are grounded. This provides a check for current leakage in the second logic state of each cell. In fact, all cells are scanned simultaneously, thus realizing a highly efficient quality check of the SRAM.

Turning now to Fig. 4, showing SRAM cell 302 in further detail. Cell 302 may be faulty in a variety of ways. A first type of defect that can occur is a short-circuit 402 from a node 404 to V_{SS} supply line 406 or a short circuit 408 from a node 410 to V_{DD} supply line 412. A second fault could be a gate oxide defect 414 bridging the gate oxide of a transistor 416 that is a functional part of one of the inverters of latch 314. Defects 402, 408 and 414 can cause memory cell 302 to have either a stuck-at fault or a data retention fault, depending on the resistance of the defect. These defects are conventionally detected by monitoring a Write/Read operation or a data retention test. However, assume that cell 302 has a gate oxide defect 414, which causes a current leakage to V_{SS}. If a logic 1 is written and read in quick succession, and if the resistance is high enough, the read operation can be successful in finding the same logic value as was written. Therefore, defect 414 need not be discovered using conventional test procedures. A quiescent current measurement traditionally conducted on SRAM 300 is able to detect fault 414. However, cells in a traditional SRAM are only sequentially accessible which implies a lengthy procedure to be carried out. In the invention, the I_{DDQ} test scans all activated cells in parallel to discover this defect. A third possible defect is a short-circuit 418 from word line WLᵢ to the V_{SS} supply line. This defect prevents access transistors 310 and 312 from being turned on, thereby permanently disabling memory cell 102. The I_{DDQ} measurements in the invention scan all cells in parallel and also detect this type of defect as it gives rise to a relatively large current. A fourth possible fault is a short circuit 420 between bit-bar line NBLⱼ and bit line BLⱼ₊₁, which is likely to occur in large capacity SRAMs whose cells are extremely small, typically in the order of 25 *µ*m², and therefore have a small column pitch. This defect 420 is readily detected in an I_{DDQ}-test according to the invention by having these adjacent lines supplied with supply voltage V_{DD} and V_{SS} alternately. Above examples may serve to illustrate the powerful test capability of an SRAM provided with test means according to the invention as all cells can be scanned in parallel.

## Claims

1. Electronic circuitry with a memory having a plurality of memory cells functionally organized in rows and columns, at least non-defective ones of said memory cells not having hot-electron injection or Fowler-Nordheim tunneling induced during testing, **characterized, in that** the circuitry comprises test circuitry for being selectively operative to connect and access simultaneously and in parallel a selective number of at least two memory cells of at least a particular one of the columns and to simultaneously subject said at least two memory cells to a quiescent current test.

2. The circuitry of claim 1, wherein the test means are operative to access in parallel all cells of a plurality of columns.

3. The circuitry of claim 2, wherein the test means are operative to access all cells of the memory in parallel.

4. The circuitry of claim 1, wherein the memory comprises a random access memory.

5. The circuitry of claim 4, wherein the random access memory includes a DRAM.

6. The circuitry of claim 4 or 5, wherein the random access memory includes an SRAM.

7. The circuitry of claim 1, wherein the memory comprises a CCD memory.

8. The circuitry of claim 1, wherein the memory comprises an LCD.

9. The circuit of claim 1, wherein the memory includes a wafer scale circuit.

10. The circuit of claim 1, wherein the test means are operative to first access in parallel all memory cells of all columns of the memory and, if thereby causing a current through the memory larger than a predetermined threshold, to then access in parallel all cells of fewer than all columns.

11. The circuit of claim 1, wherein:
- the cells in a respective one of the rows are connected to a respective word line;
- the cells in a respective one of the columns are connected to a respective bit line;
- the test means are operative to activate at least specific ones of said word lines connected to the given number of cells of the particular one of the columns, and to drive a particular one of the bit lines, which is associated with the particular column, by a quiescent voltage.

12. The circuit of claim 11, wherein the memory comprises:
- row decoding means coupled to the respective word lines for selecting a specific one of the rows upon reception of a row address associated with the specific one of the rows;
- column decoding means coupled to the respective bit lines for selecting at least a specific one of the columns upon reception of a column address associated with the specific one of the columns;
- bit line driver means coupled between the column decoding means and the columns to selectively drive the bit lines;
- pre-charging means coupled to the respective bit lines for pre-charging the respective bit lines;
and wherein the test means comprises:
- first switch means between the word lines and the row decoding means for disconnecting the word lines from the row decoding means;
- second switch means between the word lines and a supply voltage node for connecting the word lines to the supply voltage node; - control means for control of at least the pre-charging means or the bit line drivers to drive the bit line at least of the particular column.

## Patentansprüche

1. Elektronische Schaltung mit einem Speicher, der mehrere Speicherzellen hat, die funktionell in Reihen und Spalten angeordnet sind, wobei zumindest bei den nicht-defekten Zellen der genannten Speicherzellen während der Prüfung keine angeregten Elektronen injiziert werden oder eine Fowler-Nordheim-Tunnelung induziert wird, **dadurch gekennzeichnet, dass** die Schaltung einen Prüfschaltkreis umfasst, der selektiv dazu dient, simultan und parallel eine bestimmte Anzahl von mindestens zwei Speicherzellen aus mindestens einer bestimmten der Spalten zu verbinden und darauf zuzugreifen und die genannten mindestens zwei Speicherzellen simultan einer Ruhestromprüfung zu unterziehen.

2. Schaltung nach Anspruch 1, wobei die Prüfmittel dazu dienen, auf alle Zellen einer Vielzahl von Spalten parallel zuzugreifen.

3. Schaltung nach Anspruch 2, wobei die Prüfmittel dazu dienen, auf alle Zellen eines Speichers parallel zuzugreifen.

4. Schaltung nach Anspruch 1, wobei der Speicher einen Direktzugriffsspeicher umfasst.

5. Schaltung nach Anspruch 4, wobei der Direktzugriffsspeicher einen DRAM enthält.

6. Schaltung nach Anspruch 4 oder 5, wobei der Direktzugriffsspeicher einen SRAM enthält.

7. Schaltung nach Anspruch 1, wobei der Speicher einen CCD-Speicher umfasst.

8. Schaltung nach Anspruch 1, wobei der Speicher ein LCD-Element umfasst.

9. Schaltung nach Anspruch 1, wobei der Speicher eine höchstintegrierte Schaltung enthält.

10. Schaltung nach Anspruch 1, wobei die Prüfmittel dazu dienen, zuerst parallel auf alle Speicherzellen in allen Spalten des Speichers zuzugreifen und dann, falls dies einen Stromfluss im Speicher verursacht, der größer als ein vorgegebener Schwellwert ist, parallel auf alle Zellen zuzugreifen, deren Anzahl geringer als die Gesamtzahl der Spalten ist.

11. Schaltung nach Anspruch 1, wobei:
- die Zellen in jeweils einer der Reihen mit einer entsprechenden Wortleitung verbunden sind;
- die Zellen in jeweils einer der Spalten mit einer entsprechenden Bitleitung verbunden sind;
- die Prüfmittel mit Hilfe eines Ruhestroms zumindest bestimmte der genannten Wortleitungen aktivieren können, die mit der vorgegebenen Anzahl von Zellen einer bestimmten Spalte verbunden sind, und eine bestimmte Bitleitung ansteuern können, die mit der betreffenden Spalte verbunden ist.

12. Schaltung nach Anspruch 1, wobei der Speicher folgendes umfasst:
- mit den jeweiligen Wortleitungen gekoppelte Mittel zur Reihendecodierung, um nach dem Empfang einer Reihenadresse, die einer bestimmten der Reihen zugeordnet ist, eine spezielle Reihe auszuwählen;
- mit den jeweiligen Bitleitungen gekoppelte Mittel zur Spaltendecodierung, um nach dem Empfang einer Spaltenadresse, die einer bestimmten der Spalten zugeordnet ist, mindestens eine spezielle Spalte auszuwählen;
- Bitleitungstreiber-Mittel, die zwischen den Mitteln zur Spaltendecodierung und den Spalten angeordnet sind, um die Bitleitungen selektiv anzusteuern;
- Vorlade-Mittel, die mit den jeweiligen Bitleitungen zur Vorladung der entsprechenden Bitleitungen gekoppelt sind;
und wobei das Prüfmittel folgendes enthält:
- erste Schaltungsmittel zwischen den Wortleitungen und den Mitteln zur Spaltendecodierung, um die Wortleitungen von den Mitteln zur Spaltendecodierung abzutrennen;
- zweite Schaltungsmittel zwischen den Wortleitungen und einem Versorgungsspannungsknoten, um die Wortleitungen mit dem Versorgungsspannungsknoten zu verbinden;
- Steuermittel zur Steuerung zumindest der Vorlade-Mittel oder der Bitleitungstreiber, um die Bitleitung zumindest der bestimmten Spalte anzusteuern.

## Revendications

1. Circuits électroniques comprenant une mémoire comportant une pluralité de cellules de mémoire fonctionnellement organisées en rangées et en colonnes, au moins des cellules non défectueuses desdites cellules de mémoire ne comportant pas d'injection d'électrons chauds ou de franchissement par effet tunnel de Fowler-Nordheim induit durant le test, **caractérisés en ce que** les circuits comprennent des circuits de test pour fonctionner de manière sélective pour connecter et accéder simultanément et parallèlement à un nombre sélectif d'au moins deux cellules de mémoire d'au moins une particulière des colonnes et pour simultanément soumettre lesdites au moins deux cellules de mémoire à un test de courant de repos.

2. Circuits suivant la revendication 1, dans lesquels les moyens de test fonctionnent pour accéder en parallèle à toutes les cellules d'une pluralité de colonnes.

3. Circuits suivant la revendication 2, dans lesquels les moyens de test fonctionnent pour accéder à toutes les cellules de la mémoire en parallèle.

4. Circuits suivant la revendication 1, dans lesquels la mémoire comprend une mémoire à accès aléatoire.

5. Circuits suivant la revendication 4, dans lesquels la mémoire à accès aléatoire inclut une DRAM.

6. Circuits suivant la revendication 4 ou 5, dans lesquels la mémoire à accès aléatoire inclut une SRAM.

7. Circuits suivant la revendication 1, dans lesquels la mémoire comprend une mémoire CCD.

8. Circuits suivant la revendication 1, dans lesquels la mémoire comprend un LCD.

9. Circuit suivant la revendication 1, dans lequel la mémoire inclut un circuit à l'échelle d'une plaquette.

10. Circuit suivant la revendication 1, dans lequel le moyen de test fonctionne pour d'abord accéder en parallèle à toutes les cellules de mémoire de toutes les colonnes de la mémoire et, s'il amène de ce fait un courant à travers la mémoire supérieur à un seuil prédéterminé, pour ensuite accéder en parallèle à toutes les cellules de moins que toutes les colonnes.

11. Circuit suivant la revendication 1, dans lequel :
- les cellules dans une des rangées respective sont connectées à une ligne de mot respective;
- les cellules dans une des colonnes respective sont connectées à une ligne de bit respective, et
- les moyens de test fonctionnent pour activer au moins des unes spécifiques desdites lignes de mot connectées au nombre donné de cellules de la une particulière des colonnes, et pour entraîner une particulière des lignes de bit, qui est associée à la colonne particulière, par une tension de repos.

12. Circuit suivant la revendication 11, dans lequel la mémoire comprend :
- un moyen de décodage de rangée couplé aux lignes de mot respectives pour sélectionner une spécifique des rangées lors de la réception d'une adresse de rangée associée à la une spécifique des rangées;
- un moyen de décodage de colonne couplé aux lignes de bit respectives pour sélectionner au moins une spécifique des colonnes lors de la réception d'une adresse de colonne associée à la une spécifique des colonnes;
- un moyen de commande de ligne de bit couplé entre le moyen de décodage de colonne et les colonnes pour entraîner de manière sélective les lignes de bit, et
- un moyen de pré-charge couplé aux lignes de bit respectives pour pré-charger les lignes de bit respectives;
et dans lequel le moyen de test comprend :
- un premier moyen de commutation entre les lignes de mot et le moyen de décodage de rangée pour déconnecter les lignes de mot du moyen de décodage de rangée;
- un deuxième moyen de commutation entre les lignes de mot et un noeud de tension d'alimentation pour connecter les lignes de mot au noeud de tension d'alimentation, et
- un moyen de commande pour commander au moins le moyen de pré-charge ou les commandes de ligne de bit à entraîner la ligne de bit au moins de la colonne particulière.
